Europäisches Patentamt

**European Patent Office**

**Office européen des brevets**

(19)

(11) Numéro de publication : **0 441 705 A1**

(12)

# DEMANDE DE BREVET EUROPEEN

(21) Numéro de dépôt : **91400287.8**

(51) Int. Cl.⁵ : **C03C 17/245, C03C 17/34**

(22) Date de dépôt : **07.02.91**

(30) Priorité : 07.02.90 FR 9001390

(43) Date de publication de la demande :
**14.08.91 Bulletin 91/33**

(84) Etats contractants désignés :
**BE DE ES FR GB IT LU NL SE**

(71) Demandeur : **SAINT-GOBAIN VITRAGE
INTERNATIONAL
18, avenue d'Alsace
F-92400 Courbevoie (FR)**

(72) Inventeur : **Sauvinet, Vincent
47, boulevard Jules Guesde
F-93200 Saint-Denis (FR)**
Inventeur : **Oudard, Jean-François
34, Grande Rue
F-60310 Thiescourt (FR)**
Inventeur : **Cobo Hedilla, Angel F.
B. Jardin La Maruca, Chalet no. 76
E-33400 Aviles (Asturias) (ES)**

(74) Mandataire : **Le Vaguerèse, Sylvain Jacques
et al
SAINT-GOBAIN RECHERCHE 39, quai Lucien
Lefranc
F-93300 Aubervilliers Cédex (FR)**

(54) **Procédé de formation d'une couche d'oxycarbure de silicium sur du verre, verre obtenu et son utilisation dans des vitrages à couche semi-conductrice.**

(57)    Le procédé consiste à projeter, sur un substrat de verre chauffé à une température inférieure à sa température de ramollissement, un mélange gazeux comprenant du silane, un hydrocarbure saturé et un agent oxydant pour obtenir une couche d'oxycarbure de silicium.

Application à la formation de couche anticouleur utile pour supprimer l'aspect coloré en réflexion des vitrages à couche semi-conductrice.

EP 0 441 705 A1

## PROCEDE DE FORMATION D'UNE COUCHE D'OXYCARBURE DE SILICIUM SUR DU VERRE, VERRE OBTENU ET SON UTILISATION DANS DES VITRAGES A COUCHE SEMI-CONDUCTRICE

La présente invention concerne un procédé pour former sur un support de verre, une couche d'oxycarbure de silicium, un verre portant cette couche ainsi que son utilisation, en particulier, dans des vitrages comprenant une mince couche transparente semi-conductrice d'oxyde métallique présentant des propriétés de basse émissivité et ayant, en outre, une coloration neutre en réflexion.

Des vitrages destinés aux bâtiments sont avantageusement constitués en verre silico-sodo-calcique clair qui présente des facteurs de transmission lumineuse et énergétique élevés, par exemple proches de 90 % pour une épaisseur de 4 mm. Pour améliorer le confort des utilisateurs, notamment en hiver, en réduisant la perte énergétique due à une fuite de calories de l'intérieur du bâtiment vers l'extérieur, il est connu de constituer un vitrage en recouvrant une face d'une feuille de verre d'une couche semi-conductrice d'oxyde métallique, dite de basse émissivité, qui accroît le taux de réflexion du vitrage dans l'infrarouge. Un tel vitrage en verre revêtu d'une telle couche peut être associé à une autre feuille de verre non revêtue, emprisonnant entre elles un espace d'air, pour constituer un vitrage double isolant.

Des vitrages portant des revêtements transparents et présentant des propriétés de basse émissivité sont connus. Ils sont constitués par exemple d'un support de verre et d'une mince couche d'oxyde métallique telle qu'une couche d'oxyde d'étain dopé par exemple au fluor ou bien une couche d'oxyde d'indium dopé à l'étain (ITO).

Ces couches peuvent être obtenues par différents procédés, procédés sous vide (évaporation thermique, pulvérisation cathodique) ou par pyrolyse de composés métalliques sous forme de solution ou dispersion, de poudre ou de vapeur, projetés sur le substrat chauffé. Dans ce cas, les composés, au contact du verre chauffé à température élevée, mais inférieure à la température de ramollissement du verre, se décomposent et s'oxydent pour former une couche d'oxyde métallique.

Les couches, telles qu'une couche d'oxyde d'étain dopé au fluor ou une couche d'ITO, présentent des propriétés satisfaisantes pour être utilisées, notamment dans des vitrages bas émissifs.

Les propriétés optiques et électriques de ces couches les rendent aussi utilisables pour former des vitrages d'automobile, par exemple des vitrages chauffants, notamment des pare-brise, et comme substrats dans des produits particuliers, des dispositifs opto-électroniques, tels que des cellules photovoltaïques, et des dispositifs d'affichage à cristaux liquides.

Cependant, aux épaisseurs nécessaires à l'obtention de propriétés électroniques intéressantes, les couches sont colorées en réflexion. Ainsi, les couches d'oxyde d'étain dopé au fluor et les couches d'ITO, d'une épaisseur de 180 nm, sont bleues en réflexion et celles ayant une épaisseur de 300 nm sont vertes.

Cette couleur peut ne pas plaire ou ne pas être adaptée à l'utilisation envisagée. En outre, de légères variations d'épaisseur des couches entraînent des irrégularités de couleur (iridescence).

La présente invention a donc pour but la formation, sur un support de verre, d'une couche éliminant ou réduisant la coloration et/ou les irisations des couches déposées ultérieurement.

L'invention a aussi pour but de former un verre comprenant cette couche anticouleur et en outre une couche mince transparente semi-conductrice présentant des caractéristiques de transparence, basse émissivité et de conductivité électrique, utile comme vitrage bas émissif, vitrage chauffant ou substrat pour des dispositifs opto-électroniques tels que des cellules photovoltaïques et des dispositifs d'affichage à cristaux liquides.

Pour cela, l'invention concerne un procédé pour former une couche d'oxycarbure de silicium sur un support en verre, utilisable comme couche intermédiaire entre le support et une couche mince semi-conductrice.

Le procédé selon l'invention pour former une couche d'oxycarbure de silicium sur un support de verre chauffé à une température inférieure à 750°C, consiste à projeter, sur ce support, un mélange gazeux de silane, d'un hydro-carbure saturé et d'un agent oxydant.

La couche d'oxycarbure de silicium selon l'invention est obtenue par la méthode bien connue dite CVD (Chemical Vapor Deposition).

Le silane est de préférence du monosilane, mais il est possible d'utiliser d'autres silanes comme le disilane, le diméthylsilane.

L'hydrocarbure est avantageusement un hydrocarbure aliphatique saturé ayant de 1 à 4 atomes de carbone et particulièrement le propane ou le butane.

On utilise le silane et l'hydrocarbure saturé en quantité telle que le rapport en volume de l'hydrocarbure saturé au silane est compris entre 2 :1 et 5 :1.

L'agent oxydant peut être du dioxyde de carbone ou du protoxyde d'azote $N_2O$.

Le rapport en volume du dioxyde de carbone au silane est avantageusement compris entre 10 :1 et 20 :1.

Le rapport en volume de protoxyde d'azote au silane est avantageusement compris entre 1 :1 et 5 :1.

Le rapport en volume du dioxyde de carbone à l'hydrocarbure saturé est avantageusement compris entre 2 :1 et 10 :1.

Le rapport en volume du protoxyde d'azote à l'hydrocarbure saturé est avantageusement compris entre 0.5 :1 et 3 :1.

Le mélange gazeux contient en outre un gaz inerte, comme l'azote, comme gaz porteur.

Lors de la formation de la couche d'oxycarbure de silicium, le support en verre est chauffé à une température inférieure à 750°C.

Des dispositifs utiles pour former la couche selon l'invention par la méthode CVD sont par exemple décrits au brevet français 2 274 572.

La formation des couches peut avoir lieu sur la ligne de production du verre, en particulier dans le four float. Dans ce cas, le support de verre est porté à une température élevée, en particulier à une température qui correspond à la stabilité dimensionnelle du ruban de verre dans le four, c'est-à-dire à une température inférieure ou égale à 700°C. La vitesse de déplacement du verre peut être comprise entre 6 et 24 m/mn.

Les conditions de mise en oeuvre du procédé selon l'invention sont ajustées pour obtenir des couches dont l'épaisseur dépend de l'utilisation ultérieure prévue. Associées à des couches semi-conductrices, par exemple, d'oxyde d'étain dopé au fluor, d'épaisseur comprise entre 100 nm et 800 nm, qui présentent une coloration due aux interférences lumineuses, les couches d'oxycarbure de silicium selon l'invention ont avantageusement une épaisseur comprise entre 50 nm et 100 nm et un indice de réfraction compris entre 1,6 et 1,9. La couche selon l'invention joue le rôle de couche anticouleur et l'association des deux couches semi-conductrice et anticouleur forme une structure de couleur neutre.

Différentes couches semi-conductrices peuvent être déposées sur la couche d'oxycarbure de silicium selon l'invention. Ces couches peuvent être notamment des couches d'oxyde d'étain dopé au fluor, ou bien des couches d'oxyde d'indium dopé à l'étain (ITO) comme indiqué précédemment, ou bien des couches d'oxyde de zinc dopé à l'indium ou à l'aluminium. Les couches peuvent être obtenues par divers procédés, par exemple par des procédés sous vide (évaporation thermique, pulvérisation cathodique) ou par pyrolyse à partir de composés métalliques sous forme de solution ou dispersion, de poudre ou de vapeur. Dans le cas de la pyrolyse, les composés métalliques sont projetés sur le support chauffé à température élevée (supérieure à la température de décomposition thermique des composés mais inférieure à la température de ramollissement du verre) et au contact du verre chaud, les composés métalliques se décomposent et s'oxydent pour former la couche d'oxyde métallique. Les couches d'oxyde d'étain dopé au fluor peuvent être obtenues par pyrolyse de poudre, par exemple à partir de difluorure de dibutylétain (DBTF) comme décrit au brevet EP-A-178 956 ou bien à partir de mélange d'oxyde de dibutylétain (DBTO) et de DBTF comme décrit au brevet EP-A-039 256. On peut aussi les former par pyrolyse de composés à état de vapeur, notamment à partir d'un mélange de composés d'étain comme $(CH_3)_2 SnCl_2, (C_4H_9)_2 SnCl_2, Sn (C_2H_5)_4$ et de composés organofluorés tels que $CCl_2F_2$, $CHClF_2$ et $CH_3CHF_2$ comme décrit au brevet EP-A-027 403 ou bien encore à partir de monobutyltrichloroétain et un composé de formule x $CHF_2$ tel que chlorodifluorométhane mentionné dans le brevet EP-A-121 459.

Les couches semi-conductrices d'ITO peuvent être obtenues par exemple à partir de formiate d'indium et d'un composé de l'étain comme le DBTO comme décrit dans la demande de brevet EP-A- 192 009.

Les couches d'oxyde de zinc dopé à l'indium ou à l'aluminium peuvent être obtenues par pyrolyse en phase vapeur, à partir de diéthylzinc ou d'acétate de zinc et de triéthylindium, chlorure d'indium ou triéthylaluminium, chlorure d'aluminium, comme décrit dans la demande de brevet EP-A-385 769.

Les exemples suivants non limitatifs, illustrent l'invention.

## EXEMPLE 1

Sur un ruban de verre du type float, porté à une température de 700°C à l'intérieur du bain float, et se déplaçant à une vitesse de 12 m/mn, on forme, par la méthode CVD, une couche d'oxycarbure de silicium en projetant sur le verre un mélange gazeux contenant du silane, du propane, du dioxyde de carbone et de l'azote comme gaz porteur. Le rapport en volume du propane au silane est de 3 :1, celui du dioxyde de carbone au silane de 15 :1 et le rapport en volume du dioxyde de carbone au propane est de 6 :1. Le gaz porteur représente 18 % en volume du mélange. On a obtenu une couche d'oxycarbure de silicium de 80 nm d'épaisseur et d'indice de réfraction de 1,74.

## EXEMPLE 2

Dans les mêmes conditions qu'à l'exemple 1, on forme une couche d'oxycarbure de silicium sur le verre à partir d'un mélange gazeux de silane, propane, protoxyde d'azote et d'azote comme gaz porteur.

Le rapport en volume du propane au silane est de 3 :1, celui du protoxyde d'azote au silane de 2 :1 et celui du protoxyde d'azote au propane de 1 :1.

Le gaz porteur représente 44 % en volume du mélange gazeux.

On a obtenu une couche d'oxycarbure de silicium ayant une épaisseur de 90 nm et d'indice de réfraction de 1,72.

Sur les verres obtenus aux exemples 1 et 2, on a formé une couche semi-conductrice d'oxyde d'étain dopé au fluor par pyrolyse de poudre à partir de difluorure dibutylétain DBTF.

La couche a une épaisseur de 300 nm et un indice de réfraction de 2.

Dans les 2 cas, on a obtenu un vitrage ayant une transmission lumineuse de 80 % et présentant une couleur neutre en réflexion.

Les vitrages obtenus selon l'invention, c'est-à-dire comprenant un support en verre, une couche d'oxycarbure de silicium d'une épaisseur de 50 à 100 nm et une couche semi-conductrice d'épaisseur de 100 à 800 nm, telle qu'une couche d'oxyde d'étain dopé ou d'ITO, peuvent être utilisés comme vitrages bas émissifs, notamment pour le bâtiment. Un tel vitrage comprend en particulier un support de verre, une couche d'oxycarbure de silicium de 80 nm d'épaisseur et une couche d'oxyde d'étain dopé au fluor ayant une épaisseur de 300 nm environ et présentant une émissivité de 0,17 à 0,20. Un autre vitrage bas émissif selon l'invention comprend un support de verre, une couche d'oxycarbure de silicium de 80 nm d'épaisseur et une couche d'ITO d'une épaisseur de 180 nm présentant une émissivité de 0,11.

Les couches selon l'invention constituent, en outre, des couches barrière à la diffusion des ions alcalins. Les verres portant ces couches peuvent donc être utiles comme substrats dans des dispositifs opto-électroniques tels que des dispositifs d'affichage à cristaux liquides, dans lesquels la diffusion des ions alcalins, particulièrement le sodium, doit être évitée.

Les verres qui comprennent une couche d'oxycarbure de silicium selon l'invention et une couche semi-conductrice et qui ne présentent pas de coloration gênante du point de vue esthétique ou de la transmission de la lumière visible, peuvent être aussi utiles comme vitrages d'automobile par exemple des vitrages chauffants, notamment pour former des pare-brise. Dans ce cas, ces vitrages peuvent être associés à une feuille de polymère plastique tel que du polyuréthane disposée au contact de la couche semi-conductrice pour constituer un vitrage feuilleté à un seul support de verre ou bien ils sont associés à une autre plaque de verre par l'intermédiaire d'une feuille de polymère plastique tel que du polybutyralvinylique, du polyuréthane ou du polychlorure de vinyle, pour former un vitrage feuilleté à deux plaques de verre. Pour l'alimentation en courant électrique de la couche semi-conductrice, ces vitrages comprennent des amenées de courant, telles que clinquants en cuivre et/ou bandes sérigraphiées à l'argent, disposées le long des bords supérieur et inférieur des vitrages.

**Revendications**

1. Procédé de formation d'une couche d'oxycarbure de silicium sur un support en verre chauffé à une température inférieure à 750°C, par dépôt en phase vapeur (CVD), caractérisé en ce qu'on projette sur le support un mélange gazeux comprenant un silane, un hydrocarbure saturé et un agent oxydant.

2. Procédé conforme à la revendication 1, caractérisé en ce que l'hydrocarbure est un hydrocarbure aliphatique saturé ayant de 1 à 4 atomes de carbone.

3. Procédé conforme à la revendication 2, caractérisé en ce que l'hydrocarbure est le propane ou le butane.

4. Procédé conforme à l'une des revendications 1 à 3, caractérisé en ce que l'agent d'oxydant est le dioxyde de carbone ou le protoxyde d'azote.

5. Procédé conforme à l'une quelconque des revendications 1 à 4, caractérisé en ce que le rapport en volume de l'hydrocarbure saturé au silane est compris entre 2 :1 et 5 :1.

6. Procédé conforme à l'une quelconque des revendications 1 à 5, caractérisé en ce que le rapport en volume du dioxyde de carbone au silane est compris entre 10 :1 et 20 :1.

7. Procédé conforme à l'une quelconque des revendications 1 à 5, caractérisé en ce que le rapport en volume du protoxyde d'azote au silane est compris entre 1 :1 et 5 :1.

8. Procédé conforme à l'une des revendications 1 à 6, caractérisé en ce que le rapport en volume de dioxyde de carbone à l'hydrocarbure saturé est compris entre 2 :1 et 10 :1.

9. Procédé conforme à l'une des revendications 1 à 5 et 7, caractérisé en ce que le rapport en volume de protoxyde d'azote à l'hydrocarbure saturé est compris entre 0,5 :1 et 3 :1.

10. Procédé conforme à l'une quelconque des revendications 1 à 9, caractérisé en ce que la formation de la couche d'oxycarbure de silicium a lieu dans le four float.

11. Verre obtenu par le procédé conforme à l'une des revendications 1 à 10, comprenant un support en verre et une couche d'oxycarbure de silicium d'une épaisseur comprise entre 50 nm et 100 nm et ayant un indice de réfraction compris entre 1,6 et 1,9.

12. Verre conforme à la revendication 11, caractérisé en ce qu'il comprend, en outre, une mince couche transparente semi-conductrice, d'une épaisseur comprise entre 100 nm et 800 nm, formée sur la couche d'oxycarbure de silicium.

13. Verre conforme à la revendication 12, caractérisé en ce que le couche semi-conductrice est une couche d'oxyde d'étain dopé au fluor, une couche d'oxyde d'indium dopé étain ou une couche d'oxyde de zinc dopé à l'indium ou à l'aluminium.

14. Utilisation du verre selon la revendication 13, comme vitrage bas émissif, comprenant une couche semi-conductrice d'oxyde d'étain dopé au fluor présentant une émissivité de 0,17 à 0,20 pour une épaisseur de 300 nm environ.

15. Utilisation du verre selon la revendication 13, comme vitrage bas émissif, comprenant une couche semi-conductrice d'oxyde indium dopé à l'étain, présentant une émissivité de 0,11 pour une épaisseur de 180 nm.

16. Utilisation du verre conforme à l'une des revendications 12 et 13 comme substrat pour dispositifs opto-électroniques.

17. Utilisation du verre conforme à l'une des revendications 12 et 13 comme substrat ayant des propriétés de barrière aux ions alcalins pour dispositif d'affichage à cristaux liquides.

18. Utilisation du verre conforme à l'une des revendications 12 et 13, comme vitrage feuilleté chauffant comprenant, au contact de la couche semi-conductrice, une feuille de polymère plastique, notamment de polyuréthane, et des amenées de courant disposées le long des bords supérieur et inférieur du vitrage.

19. Utilisation du verre conforme à l'une des revendications 12 et 13 comme vitrage feuilleté chauffant comprenant, au contact de la couche semi-conductrice, une feuille intercalaire de polymère plastique du type PVB, PVC ou PU, associée à une plaque de verre, et des amenées de courant disposées le long des bords supérieur et inférieur du vitrage.

Office européen
des brevets

**RAPPORT DE RECHERCHE EUROPEENNE**

Numéro de la demande

EP 91 40 0287

| DOCUMENTS CONSIDERES COMME PERTINENTS | | | |
|---|---|---|---|
| Catégorie | Citation du document avec indication, en cas de besoin, des parties pertinentes | Revendication concernée | CLASSEMENT DE LA DEMANDE (Int. Cl.5) |
| A | PATENT ABSTRACTS OF JAPAN, vol. 10, no. 2 (M-444), 8 janvier 1986; & JP-A-60 166 471 (HITACHI SEISAKUSHO) 29-08-1985 * Résumé entier * --- | 1 | C 03 C 17/245 C 03 C 17/34 |
| A | EP-A-0 348 185 (PILKINGTON PLC) * Revendications * --- | 1 | |
| A | FR-A-2 545 983 (L'AIR LIQUIDE) * Revendications * --- | 1 | |
| A | GB-A-2 199 848 (PILKINGTON PLC) * Revendications * ----- | 1 | |
| | | | DOMAINES TECHNIQUES RECHERCHES (Int. Cl.5) |
| | | | C 03 C |

Le présent rapport a été établi pour toutes les revendications

| Lieu de la recherche | Date d'achèvement de la recherche | Examinateur |
|---|---|---|
| LA HAYE | 09-04-1991 | BOUTRUCHE J.P.E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

                                                                           
& : membre de la même famille, document correspondant

EPO FORM 1503 03.82 (P0402)